# EUROPÄISCHE PATENTSCHRIFT

(11) **EP 1 639 315 B1**
(45) Veröffentlichungstag und Bekanntmachung des Hinweises auf die Patenterteilung: **25.11.2009**
(21) Anmeldenummer: 04741662.3
(22) Anmeldetag: 27.05.2004
(51) Int. Cl.: G01C 19/56, G01P 9/04

(54) **VERFAHREN ZUR ÜBERWACHUNG EINES DREHRATENSENSORS**
METHOD FOR MONITORING A ROTATION RATE SENSOR
PROCEDE DE SURVEILLANCE D'UN CAPTEUR DE VITESSE DE ROTATION

(30) Priorität: 30.06.2003 DE 10329498
(43) Veröffentlichungstag der Anmeldung: 29.03.2006
(73) Patentinhaber: Continental Automotive GmbH, 30165 Hannover (DE)
(72) Erfinder: MORELL, Heinz-Werner, 67659 Kaiserslautern (DE); SCHMID, Dietmar, 65606 Villmar (DE); SKORUPA, Raphael, 61348 Bad Homburg (DE)
(86) Internationale Anmeldenummer: PCT/EP2004/050941
(87) Internationale Veröffentlichungsnummer: WO 2005/001378

(56) Entgegenhaltungen:
- DE-A- 19 845 185
- US-A1- 2002 178 813

## Beschreibung

Die Erfindung betrifft ein Verfahren zur Überwachung eines Drehratensensors mit einem Vibrationskreisel, der ein Bandfilter darstellt und Teil mindestens eines Regelkreises ist, der aus Digital- und Analog-Komponenten besteht und der den Vibrationskreisel durch Zuführung eines Erregersignals mit seiner Eigenfrequenz erregt, wobei dem Vibrationskreisel ein Ausgangssignal entnehmbar ist, aus dem durch Filterung und Verstärkung das Erregersignal und ein Drehratensignal abgeleitet werden.

Beispielsweise aus EP 0 461 761 B1 sind Drehratensensoren bekannt geworden, bei welchen ein Vibrationskreisel in zwei radial ausgerichteten Achsen angeregt wird, wozu ein primärer und ein sekundärer Regelkreis mit entsprechenden Wandlern an dem Vibrationskreisel vorgesehen sind. Werden derartige Drehratensensoren in Fahrzeugen zur Stabilisierung der Fahrzeugbewegung eingesetzt, so können durch Ausfall oder fehlerhafte Funktion Gefährdungen auftreten. Um diese zu vermeiden, ist eine Funktionsüberwachung des Drehratensensors erforderlich.

Eine solche Überwachung ist mit dem erfindungsgemäßen Verfahren dadurch möglich, dass mit Hilfe von redundanten Analog-Komponenten und mindestens einem Analog/Digital-Wandler Analogsignale gemessen und charakteristische Werte innerhalb der Digital-Komponenten gelesen und jeweils mit Grenzwerten verglichen werden.

Das erfindungsgemäße Verfahren ermöglicht eine weitgehend vollständige Überwachung des Drehratensensors während des Betriebes, wobei Fehler sowohl in den Analog-Komponenten als auch in den Digital-Komponenten erkannt werden. Es ist jedoch nicht ausgeschlossen, dass in Kombination mit dem erfindungsgemäßen Verfahren oder innerhalb von Weiterbildungen des erfindungsgemäßen Verfahrens Maßnahmen zu einer weiteren Überwachung zu gegebenen Zeitpunkten, beispielsweise beim Einschalten des Drehratensensors, insbesondere beim Einschalten der Zündung oder beim Stillstand des Kraftfahrzeugs, durchgeführt werden können.

Eine Weiterbildung des erfindungsgemäßen Verfahrens besteht darin, dass ferner das Erregersignal mit einem Modulationssignal moduliert wird, dessen Frequenz innerhalb des Durchlassbereichs des Bandfilters, jedoch außerhalb des Frequenzbereichs des Drehratensignals liegende Seitenbänder bewirkt, dass die Amplitude des Modulationssignals im Ausgangssignal gemessen wird und dass eine Fehlermeldung abgegeben wird, wenn die Amplitude unter einem vorgegebenen Schwellwert liegt.

Durch diese Weiterbildung ist eine Überwachung der Funktion des gesamten Regelkreises einschließlich des Vibrationskreisels während des Betriebes möglich, ohne dass die Funktion des Drehratensensors in irgendeiner Weise beeinflusst wird.

Die Weiterbildung kann derart ausgeführt sein, dass das Ausgangssignal nach Verstärkung und Analog/Digital-Wandlung in eine Inphase- und eine Quadratur-Komponente demoduliert wird, dass die Inphase- und die Quadratur-Komponente nach Filterung wieder moduliert und zum Erregersignal zusammengesetzt werden und dass das Modulationssignal den demodulierten Komponenten hinzugefügt wird.

Eine vorteilhafte Ausgestaltung der Weiterbildung besteht darin, dass den demodulierten Komponenten vor dem Hinzufügen des Modulationssignals Messsignale entnommen werden, welche synchron demoduliert werden. Dabei ist vorzugsweise vorgesehen, dass Messsignale vor und nach einer Filterung der demodulierten Ausgangssignale abgeleitet werden.

Da die durch die Modulation entstandenen Seitenbänder und damit auch das Modulationssignal sowie die Messsignale äußerst geringe Amplituden aufweisen, kann zur Unterdrückung des Rauschens vorgesehen sein, dass die synchron demodulierten Messsignale über eine vorgegebene Zeit integriert werden und dass der Wert des Integrals mit dem vorgegebenen Schwellwert verglichen wird. Alternativ kann das Verfahren auch derart ausgebildet sein, dass die synchron demodulierten Messsignale integriert werden und dass die Zeit gemessen wird, bis die integrierten Messsignale einen vorgegebenen Schwellwert erreichen.

Bei den bekannten Vibrationskreiseln hat es sich als günstig herausgestellt, wenn das Modulationssignal eine Frequenz von 200 Hz aufweist.

Eine andere Weiterbildung des erfindungsgemäßen Verfahrens besteht darin, dass das Drehratensignal vom Ausgang des Drehratensensors gelesen und mit einem Ausgangsstufen zugeführten Drehratensignal verglichen wird. Hiermit ist insbesondere eine Überprüfung der Ausgangsstufen daraufhin möglich, ob das Drehratensignal fehlerfrei weitergeleitet wird.

Eine Überprüfung des an ein anderes System weitergeleiteten Drehratensignals kann dadurch durchgeführt werden, dass ein an den Ausgang angeschlossenes System das Drehratensignal an seinem Eingang zur Prüfung zurücksendet.

Eine andere Weiterbildung der Erfindung besteht darin, dass die Digital- und Analog-Komponenten laufend von Kontrollkomponenten kontrolliert werden und dass Überwachungskomponenten die Kontrollkomponenten mindestens einmal während eines Betriebszyklus überwachen.

Ein Vorteil dieser Weiterbildung besteht darin, dass durch die laufende Überwachung schnelle Fehlermeldungen möglich sind, die dem Benutzer und übergeordneten Systemen den Fehler und damit das eventuell fehlerhafte Drehratensignal melden. Diese schnelle Reaktion wird ergänzt durch eine Überwachung der Kontrollkomponenten, so dass auch Fehler gemeldet werden, die zwar nicht unmittelbar zu einem falschen Drehratensignal führen, jedoch bei Auftreten eines zweiten Fehlers zu Gefährdungen führen können. Eine Redundanz der Digital- und Analog-Komponenten ist dazu nur in einem geringen Umfang erforderlich.

Die Erfindung lässt zahlreiche Ausführungsformen zu. Eine davon ist schematisch in der Zeichnung anhand mehrerer Figuren dargestellt und nachfolgend beschrieben. Es zeigt:
- Figur 1: ein Blockschaltbild eines Drehratensensors,
- Figur 2: eine detailliertere Darstellung des Drehratensensors nach Fig. 1 und
- Figur 3: einen sekundären Regelkreis im Drehratensensor.

Das Ausführungsbeispiel sowie Teile davon sind zwar als Blockschaltbilder dargestellt. Dieses bedeutet jedoch nicht, dass die erfindungsgemäße Anordnung auf eine Realisierung mit Hilfe von einzelnen den Blöcken entsprechenden Schaltungen beschränkt ist. Die erfindungsgemäße Anordnung ist vielmehr in besonders vorteilhafter Weise mit Hilfe von hochintegrierten Schaltungen realisierbar. Dabei können Mikroprozessoren eingesetzt werden, welche bei geeigneter Programmierung die in den Blockschaltbildern dargestellten Verarbeitungsschritte durchführen.

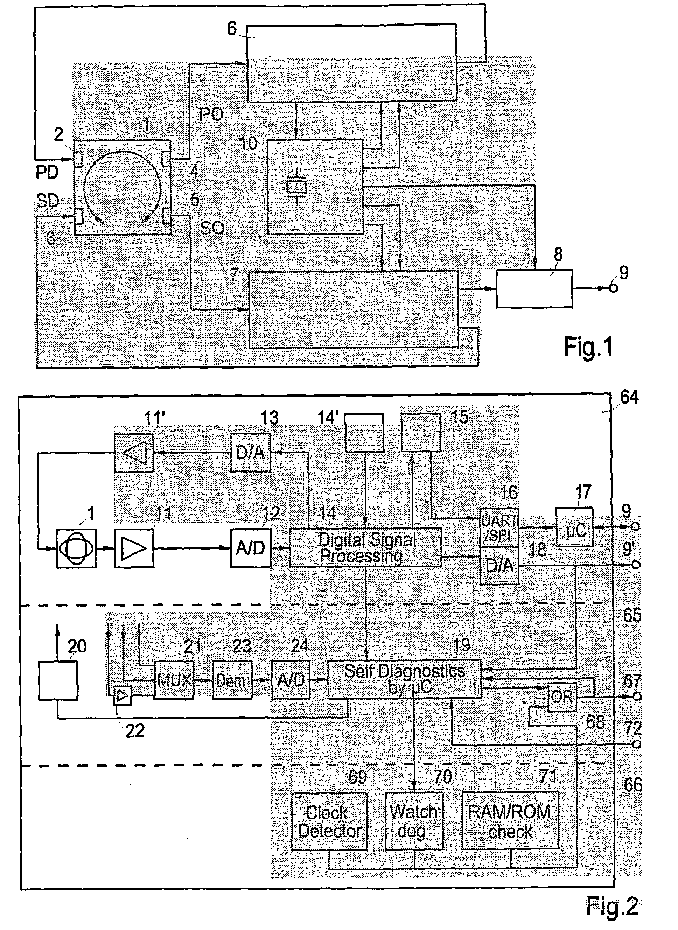

Figur 1 zeigt ein Blockschaltbild einer Anordnung mit einem Vibrationskreisel 1 mit zwei Eingängen 2, 3 für ein primäres Erregersignal PD und ein sekundäres Erregersignal SD. Die Erregung erfolgt durch geeignete Wandler, beispielsweise elektromagnetische. Der Vibrationskreisel weist ferner zwei Ausgänge 4, 5 für ein primäres Ausgangssignal PO und ein sekundäres Ausgangssignal SO auf. Diese Signale geben die jeweilige Vibration an räumlich versetzten Stellen des Kreisels wieder. Derartige Kreisel sind beispielsweise aus EP 0 307 321 A1 bekannt und beruhen auf der Wirkung der Corioliskraft.

Der Vibrationskreisel 1 stellt ein Filter hoher Güte dar, wobei die Strecke zwischen dem Eingang 2 und dem Ausgang 4 Teil eines primären Regelkreises 6 und die Strecke zwischen dem Eingang 3 und dem Ausgang 5 Teil eines sekundären Regelkreises 7 ist. Der primäre Regelkreis 6 dient zur Anregung von Schwingungen mit der Resonanzfrequenz des Vibrationskreisels von beispielsweise 14 kHz. Die Anregung erfolgt dabei in einer Achse des Vibrationskreisels, zu welcher die für den sekundären Regelkreis benutzte Schwingungsrichtung um 90° versetzt ist. Im sekundären Regelkreis 7 wird das Signal SO in eine Inphase- und eine Quadratur-Komponente aufgespalten, von denen eine über ein Filter 8 einem Ausgang 9 zugeleitet wird, von welchem ein der Drehrate proportionales Signal abnehmbar ist.

In beiden Regelkreisen 6, 7 erfolgt ein wesentlicher Teil der Signalverarbeitung digital. Die zur Signalverarbeitung erforderlichen Taktsignale werden in einem quarzgesteuerten digitalen Frequenz-Synthesizer 10 erzeugt, dessen Taktfrequenz im dargestellten Beispiel 14,5 MHz beträgt.

Bei dem Blockschaltbild gemäß Figur 2 sind Komponenten in Sektionen 64, 65, 66 aufgeteilt. Dabei sind in einer Funktionssektion 64 alle Komponenten zusammengefasst, die der eigentlichen Funktion des Drehratensensors dienen. Eine Kontrollsektion 65 enthält Komponenten zur laufenden Kontrolle der Komponenten in der Funktionssektion 64. Eine Überwachungssektion 66 enthält Komponenten, die von Zeit zu Zeit die Komponenten der Kontrollsektion 65 überwachen. So sind beispielsweise zum Betrieb des Vibrationskreisels 1 zwei Verstärker 11, 11', ein Analog/Digital-Wandler 12 und ein Digital/Analog-Wandler 13 vorgesehen. Weitere Komponenten, beispielsweise Filter, sind zum Verständnis der Erfindung nicht erforderlich und daher nicht näher dargestellt und erläutert. Die vom Vibrationskreisel 1 abgenommenen, bei 11 verstärkten und bei 12 digitalisierten Signale werden bei 14 digital verarbeitet, woraus ein Treibersignal entsteht, das über den Digital/Analog-Wandler 13 und den Verstärker 11' einem Eingang des Vibrationskreisels zugeführt wird.

Beim Einschalten werden aus einem nichtflüchtigen Speicher 14' Abgleichdaten geladen. Über einen Mikrocomputer 15 werden aus der digitalen Signalverarbeitung 14 Daten entnommen, welche das Drehratensignal beinhalten, und über eine UART/SPI-Schnittstelle 16 einem weiteren Mikrocomputer 17 zugeleitet. Dieser führt ein digitales Drehratensignal an den Ausgang 9. Parallel dazu ist an die digitale Signalverarbeitung 14 ein Digital/Analog-Wandler 18 angeschlossen, an dessem Ausgang 9' ein analoges Drehratensignal anliegt.

Die Kontrollsektion 65 wird im Wesentlichen von einer Selbstdiagnose 19 durch den Mikrocomputer gebildet, wobei Daten der digitalen Signalverarbeitung 14 zur Verfügung stehen. Außerdem weist die Kontrollsektion 65 zur Prüfung von Analog-Komponenten der Funktionssektion 64 einen von der Selbstdiagnose 19 steuerbaren Testsignalinjektor 20 auf, der analoge Testsignale an wählbaren Stellen den Analogschaltungen der Funktionssektion 64 zuführen kann. Mehrere Punkte der Analogschaltungen der Funktionssektion 64 sind mit einem Multiplexer 21 verbunden, so dass ein wählbares Analogsignal kontrolliert werden kann.

Für den Fall, dass eines dieser Analogsignale eine kleinere Amplitude aufweisen sollte, ist ein Verstärker 22 vorgesehen. Bei dem Ausführungsbeispiel sind die zu kontrollierenden Analogsignale trägerfrequent. Deshalb schließt sich an den Multiplexer 21 ein Demodulator 23 an. Nach einer Analog/DigitalWandlung 24 kann die Selbstdiagnose 19 auf die zu kontrollierenden Analogsignale zugreifen. Zur weiteren Prüfung erhält die Selbstdiagnose 19 vom Ausgang 9' das analoge Ausgangssignal und vom Ausgang 67 das Alarmsignal. Stellt die Selbstdiagnose 19 einen Fehler fest, wird über die Oderschaltung 68 und den Ausgang 67 ein Alarmsignal abgegeben. Zusätzlich erfolgt eine Alarmsignalisierung über ein Statusbit im Datentelegramm der UART/SPI-Schnittstelle.

Die Überwachung des Programmlaufs im Mikrocomputer, sowie des Vorhandenseins eines Taktsignals und die einwandfreie Funktion der Speicher werden in der Überwachungssektion 66 mit Hilfe eines Taktdetektors 69, eines Watchdogs 70 und einer RAM/ROM-Prüfung 71 durchgeführt. Stellt eine dieser Komponenten einen Fehler fest, wird über die Oderschaltung 68 und den Ausgang 67 ein Alarmsignal ausgegeben. Über einen Eingang 72 kann eine Selbstdiagnose gestartet werden, beispielsweise bei Wartungsarbeiten oder in einer Betriebspause des Fahrzeugs.

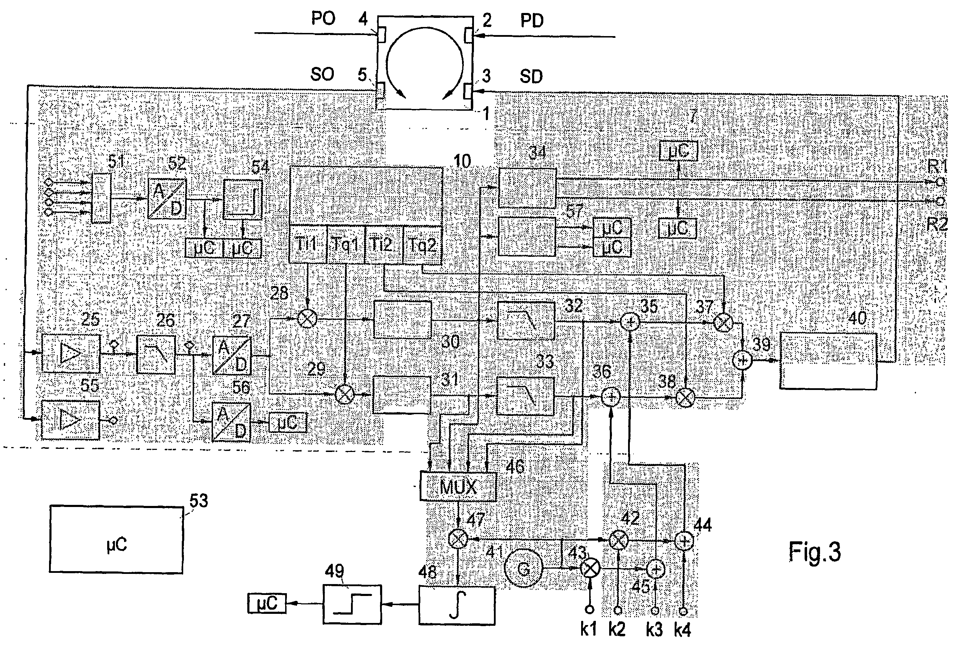

Der sekundäre Regelkreis 7 ist in Figur 3 als Blockschaltbild dargestellt und enthält einen Verstärker 25, ein Anti-Alias-Filter 26 und einen Analog/Digital-Wandler 27. Mit Hilfe von Multiplizierern 28, 29, denen das verstärkte und digitalisierte Signal SO und Träger Ti1 und Tq1 zugeführt werden, erfolgt eine Aufspaltung in Realteil und Imaginärteil.

Beide Komponenten durchlaufen anschließend je ein (sinx/x)-Filter 30, 31 und ein Tiefpassfilter 32, 33. Aus dem gefilterten Realteil werden mit Hilfe einer Aufbereitungsschaltung 34 zwei Signale R1 und R2 abgeleitet, welche die mit dem Drehratensensor zu messende Drehrate darstellen. Die Signale R1 und R2 unterscheiden sich dadurch, dass das Signal R2 nicht den gesamten durch die verwendete Schaltungstechnik möglichen Amplitudenbereich von beispielsweise 0V bis +5V einnimmt. Zur Ausgabe einer Fehlermeldung wird das Signal R2 auf Null gelegt, was das angeschlossene System als Fehlermeldung erkennt.

Den Tiefpassfiltern 32, 33 ist je ein Addierer 35, 36 nachgeschaltet. Anschließend erfolgt mit Hilfe von Multiplizierern 37, 38 eine Remodulation beider Komponenten Si bzw. Sq mit Trägern Ti2 und Tq2. Eine Addition bei 39 ergibt wieder eine 14-kHz-Schwingung, die in einem Ausgangstreiber 40 in einen zur Anregung des Vibrationskreisels 1 geeigneten Strom umgewandelt wird.

Zur Kontrolle des sekundären Regelkreises wird in einem Generator 41 ein Modulationssignal von 200 Hz erzeugt. In zwei Multiplizierern 42, 43 wird dieses Signal mit Konstanten k1 und k2 multipliziert, die einstellbar sind bzw. bei Einschalten aus einem Speicher geladen werden, wodurch unabhängig voneinander die Amplituden des Modulationssignals für die beiden Komponenten einstellbar ist. In anschließenden Addierern 44, 45 werden einstellbare Vorspannungen k3 und k4 hinzuaddiert. Die somit abgeleiteten Komponenten des Modulationssignals werden in den Addierern 35 und 36 den beiden Komponenten des demodulierten Ausgangssignals hinzuaddiert. Durch die anschließenden Multiplizierer 37, 38 und den Addierer 39 wird dann das Trägersignal mit dem wieder zusammengefassten demodulierten Ausgangssignal und zusätzlich mit dem Modulationssignal moduliert.

Die vom Ausgang 5 des Vibrationskreisels nach Verstärkung, Anti-Alias-Filterung 26, Analog/Digital-Wandlung und Demodulation bei 28, 39 gewonnenen Komponenten werden jeweils vor den Filtern 32, 33 und nach den Filtern 32, 33 abgegriffen und als Messsignale einem Multiplexer 46 zugeführt, dessen Ausgang mit einem Multiplizierer 47 verbunden ist, der als Synchron-Demodulator dient. Dessen Ausgangssignal wird bei 48 über eine größere Anzahl von Perioden integriert und einer Schwellwertschaltung 49 zugeleitet. Das Vorhandensein des Modulationssignals wird dadurch festgestellt, dass innerhalb einer vorgegebenen Zeit das Integral einen vorgegebenen Schwellwert überschreitet, was einen Mikrocomputer 53 zu einer Fehlermeldung veranlasst.

Neben dieser Überwachung des sekundären Regelkreises befinden sich noch andere Kontrolleinrichtungen bei dem Ausführungsbeispiel nach Figur 3. So sind beispielsweise Messpunkte, die nach und nach mit Hilfe eines Multiplexers 51 mit dem Eingang eines Analog/Digital-Wandlers 52 verbunden werden, an verschiedenen Stellen des Drehratensensors angeordnet und mit einem Rhombus gekennzeichnet. Der Wert am Ausgang des Analog/Digital-Wandlers 52 stellt also jeweils die Größe eines der gemessenen Analogsignale dar und kann unmittelbar von einem Mikrocomputer 53 überwacht oder über einen Spitzenwertdetektor 54 an den Mikrocomputer 53 weitergeleitet werden.

Als hiermit zu messende und damit zu überwachende Analogsignale sind beispielhaft aufgeführt: das Ausgangssignal des Verstärkers 25, das Ausgangssignal der Treiberschaltung 40, das Ausgangssignal des Anti-Alias-Filter 26. Weitere Messpunkte können in nicht dargestellten Schaltungen, beispielsweise Spannungsversorgungsschaltungen oder am Analogausgang 9' (Figur 2) vorgesehen sein.

Wegen der geringen Amplitude und des geringen Störabstandes kann das Ausgangssignal SO des Vibrationskreisels 1 nicht unmittelbar gemessen werden, deshalb ist parallel zum Verstärker 25 ein redundanter Verstärker 55 vorgesehen, dessen Ausgang ebenfalls einen der Messpunkte darstellt. Durch einen Vergleich beider Ausgangsspannungen kann festgestellt werden, ob das Ausgangssignal SO des Vibrationskreisels 1 oder einer der Verstärker 25, 55 fehlerhaft ist.

Dem Analog/Digital-Wandler 27 ist ein redundanter Analog/Digital-Wandler 56 zugeordnet, dessen Ausgang vom Mikrocomputer 53 ebenso wie der Ausgang des Analog/DigitalWandlers 27 abgefragt werden kann. Ein Vergleich der Ausgangswerte beider Analog/Digital-Wandler lässt ebenfalls Rückschlüsse auf Defekte bei den Analog/Digital-Wandlern oder bei den vorangegangenen Schaltungen zu.

Zur Kontrolle des Drehratensignals befindet sich in der Anordnung nach Figur 3 eine redundante Aufbereitungsschaltung 57, deren Ausgang ebenfalls vom Mikrocomputer 53 abgefragt werden kann. Durch einen Vergleich mit den Ausgangswerten der Aufbereitungsschaltung 34 sind ebenfalls Rückschlüsse auf die Art der Fehler möglich, insbesondere ob eine der Aufbereitungsschaltungen 34, 57 fehlerhaft arbeitet.

## Patentansprüche

1. Verfahren zur Überwachung eines Drehratensensors mit einem Vibrationskreisel (1), der ein Bandfilter darstellt und Teil mindestens eines Regelkreises (6,7) ist, der aus Digital- und Analog-Komponenten besteht und der den Vibrationskreisel (1) durch Zuführung eines Erregersignals mit seiner Eigenfrequenz erregt, wobei dem Vibrationskreisel (1) ein Ausgangssignal entnehmbar ist, aus dem durch Filterung und Verstärkung das Erregersignal und ein Drehratensignal abgeleitet werden, **dadurch gekennzeichnet, dass** mit Hilfe von redundanten Analog-Komponenten (55) und mindestens einem Analog/Digital-Wandler (52) Analogsignale gemessen und charakteristische Werte innerhalb der Digital-Komponenten gelesen und jeweils mit Grenzwerten verglichen werden.

2. Verfahren nach Anspruch 1, **dadurch gekennzeichnet, dass** ferner das Erregersignal mit einem Modulationssignal moduliert wird, dessen Frequenz innerhalb des Durchlassbereichs des Bandfilters, jedoch außerhalb des Frequenzbereichs des Drehratensignals liegende Seitenbänder bewirkt, dass die Amplitude des Modulationssignals im Ausgangssignal gemessen wird und dass eine Fehlermeldung abgegeben wird, wenn die Amplitude unter einem vorgegebenen Schwellwert liegt.

3. Verfahren nach Anspruch 2, **dadurch gekennzeichnet, dass** das Ausgangssignal nach Verstärkung und Analog/Digital-Wandlung in eine Inphase- und eine Quadratur-Komponente demoduliert wird, dass die Inphase- und die Quadratur-Komponente nach Filterung wieder moduliert und zum Erregersignal zusammengesetzt werden und dass das Modulationssignal den demodulierten Komponenten hinzugefügt wird.

4. Verfahren nach Anspruch 3, **dadurch gekennzeichnet, dass** den demodulierten Komponenten vor dem Hinzufügen des Modulationssignals Messsignale entnommen werden, welche synchron demoduliert werden.

5. Verfahren nach Anspruch 4, **dadurch gekennzeichnet, dass** Messsignale vor und nach einer Filterung der demodulierten Ausgangssignale abgeleitet werden.

6. Verfahren nach einem der Ansprüche 4 oder 5, **dadurch gekennzeichnet dass** die synchron demodulierten Messsignale über eine vorgegebene Zeit integriert werden und dass der Wert des Integrals mit dem vorgegebenen Schwellwert verglichen wird.

7. Verfahren nach einem der Ansprüche 4 oder 5, **dadurch gekennzeichnet, dass** die synchron demodulierten Messsignale integriert werden und dass die Zeit gemessen wird, bis die integrierten Messsignale einen vorgegebenen Schwellwert erreichen.

8. Verfahren nach einem der Ansprüche 2 bis 7, **dadurch gekennzeichnet dass** das Modulationssignal eine Frequenz von 200 Hz aufweist.

9. Verfahren nach einem der vorhergehenden Ansprüche, **dadurch gekennzeichnet, dass** das Drehratensignal vom Ausgang des Drehratensensors gelesen und mit einem Ausgangsstufen zugeführten Drehratensignal verglichen wird.

10. Verfahren nach einem der vorhergehenden Ansprüche, **dadurch gekennzeichnet, dass** ein an den Ausgang angeschlossenes System das Drehratensignal an seinem Eingang zur Prüfung zurücksendet.

11. Verfahren nach einem der vorhergehenden Ansprüche, **dadurch gekennzeichnet, dass** die Digital- und Analog-Komponenten laufend von Kontrollkomponenten kontrolliert werden und dass Überwachungskomponenten die Kontrollkomponenten mindestens einmal während eines Betriebszyklus überwachen.

## Claims

1. Method for monitoring a rotation rate sensor having a vibration gyro (1), which represents a bandpass filter and is part of at least one control loop (6,7) which comprises digital and analog components and excites the vibration gyro (1) by supplying an excitation signal at its natural frequency, in which case an output signal can be tapped off from the vibration gyro (1), from which the excitation signal and a rotation rate signal are derived by filtering and amplification, **characterized in that** analog signals are measured and characteristic values within the digital components are read, and are in each case compared with limit values, by means of redundant analog components (55) and at least one analog/digital converter (52).

2. Method according to Claim 1, **characterized in that** the excitation signal is also modulated with a modulation signal whose frequency produces sidebands which are located within the pass band of the bandpass filter, but are outside the frequency range of the rotation rate signal, **in that** the amplitude of the modulation signal in the output signal is measured, and **in that** a fault message is emitted if the amplitude is less than a predetermined threshold value.

3. Method according to Claim 2, **characterized in that** the output signal is demodulated, after amplification and analog/digital conversion, into an in-phase and a quadrature component, **in that** the in-phase component and the quadrature component are modulated again after filtering and are combined to form the excitation signal, and **in that** the modulation signal is added to the demodulated components.

4. Method according to Claim 3, **characterized in that** measurement signals are taken from the demodulated components before the addition of the modulation signal, and are demodulated synchronously.

5. Method according to Claim 4, **characterized in that** measurement signals are tapped off before and after filtering of the demodulated output signals.

6. Method according to one of Claims 4 or 5, **characterized in that** the synchronously demodulated measurement signals are integrated over a predetermined time, and **in that** the value of the integral is compared with the predetermined threshold value.

7. Method according to one of Claims 4 or 5, **characterized in that** the synchronously demodulated measurement signals are integrated, and **in that** the time which the integrated measurement signals take to reach a predetermined threshold value is measured.

8. Method according to one of Claims 2 to 7, **characterized in that** the modulation signal is at a frequency of 200 Hz.

9. Method according to one of the preceding claims, **characterized in that** the rotation rate signal is read from the output of the rotation rate sensor, and is compared with a rotation rate signal which is supplied to output stages.

10. Method according to one of the preceding claims, **characterized in that** a system which is connected to the output sends back the rotation rate signal to its input for checking.

11. Method according to one of the preceding claims, **characterized in that** the digital and analog components are continuously checked by checking components, and **in that** monitoring components monitor the checking components at least once during one operating cycle.

## Revendications

1. Procédé permettant de surveiller un capteur de vitesse de rotation comportant un gyroscope à vibrations (1), lequel constitue un filtre à bande et fait partie de au moins un circuit de régulation (6, 7) composé de constituants numériques et analogiques et qui excite le gyroscope à vibrations (1) en lui envoyant un signal d'excitation ayant sa fréquence propre, où on peut prélever du gyroscope à vibrations (1) un signal de sortie à partir duquel sont dérivés, par filtrage et amplification, le signal d'excitation et un signal de vitesse de rotation, **caractérisé par le fait que**, à l'aide de constituants analogiques redondants (55) et de au moins un convertisseur analogique/numérique (52), des signaux analogiques sont mesurés et des valeurs caractéristiques sont lues à l'intérieur des constituants numériques et comparées une par une à des valeurs seuils.

2. Procédé selon la revendication 1, **caractérisé par le fait que**, en outre, le signal d'excitation est modulé avec un signal de modulation dont la fréquence produit des bandes latérales situées à l'intérieur de la bande passante du filtre à bande, mais à l'extérieur de la bande de fréquence du signal de vitesse de rotation, que l'amplitude du signal de modulation est mesurée dans le signal de sortie et qu'un message d'erreur est émis lorsque l'amplitude est inférieure à une valeur seuil donnée.

3. Procédé selon la revendication 2, **caractérisé par le fait que** le signal de sortie est démodulé après amplification et conversion analogique/numérique en une composante en phase et une composante en quadrature de phase, que la composante en phase et la composante en quadrature de phase sont, après filtrage, modulées de nouveau et assemblées pour former le signal d'excitation et que le signal de modulation est ajouté aux composantes démodulées.

4. Procédé selon la revendication 3, **caractérisé par le fait qu'**on extrait des composantes démodulées, avant l'adjonction du signal de modulation, des signaux de mesure qui sont démodulés en synchronisation.

5. Procédé selon la revendication 4, **caractérisé par le fait que** des signaux de mesure sont dérivés avant et après un filtrage des signaux de sortie démodulés.

6. Procédé selon l'une des revendications 4 ou 5, **caractérisé par le fai**t qu'on effectue l'intégration sur une période de temps donnée des signaux de mesure démodulés en synchronisation et que la valeur de l'intégrale est comparée à la valeur seuil donnée.

7. Procédé selon l'une des revendications 4 ou 5, **caractérisé par le fait qu'**on effectue l'intégration des signaux de mesure démodulés en synchronisation et qu'on mesure le temps qui s'écoule jusqu'à ce que l'intégrale des signaux de mesure atteigne une valeur seuil donnée.

8. Procédé selon l'une des revendications 2 à 7, **caractérisé par le fait que** le signal de modulation a une fréquence de 200 Hz.

9. Procédé selon l'une des revendications précédentes, **caractérisé par le fait qu'**on lit le signal de vitesse de rotation de la sortie du capteur de vitesse de rotation et on le compare à un signal de vitesse de rotation appliqué aux étages de sortie.

10. Procédé selon l'une des revendications précédentes, **caractérisé par le fait qu'**un système raccordé à la sortie renvoie, pour le contrôler, le signal de vitesse de rotation à son entrée.

11. Procédé selon l'une des revendications précédentes, **caractérisé par le fait que** les constituants numériques et analogiques sont contrôlés en permanence par des constituants de contrôle et que des constituants de surveillance surveillent les constituants de contrôle au moins une fois pendant chaque cycle de fonctionnement.
